# EUROPÄISCHE PATENTSCHRIFT

(11) **EP 0 691 048 B1**
(45) Veröffentlichungstag und Bekanntmachung des Hinweises auf die Patenterteilung: **22.01.1997**
(21) Anmeldenummer: 94908978.3
(22) Anmeldetag: 17.03.1994
(51) Int. Cl.: H03H 17/02

(54) **DIGITALES FILTER**
DIGITAL FILTER
FILTRE NUMERIQUE

(30) Priorität: 24.03.1993 DE 4309518
(43) Veröffentlichungstag der Anmeldung: 10.01.1996
(73) Patentinhaber: Blaupunkt-Werke GmbH, D-31132 Hildesheim (DE)
(72) Erfinder: HERRMANN, Matthias, D-31141 Hildesheim (DE)
(74) Vertreter: Friedmann, Jürgen, Dr.-Ing.
(86) Internationale Anmeldenummer: DE9400294
(87) Internationale Veröffentlichungsnummer: WO9422219

(56) Entgegenhaltungen:
- EP-A- 0 135 024
- ELECTRONICS AND COMMUNICATIONS IN JAPAN, Bd.67, Nr.8, August 1984, NEW YORK US Seiten 31 - 40 NOBUAKI TAKAHASHI ET AL 'A NEW RECURSIVE STRUCTURE FOR VERY HIGH-Q DIGITAL AND SC-CTD FILTERS'

## Beschreibung

Die Erfindung betrifft ein digitales Filter, das zwischen einer ersten Charakteristik und einer zweiten Charakteristik umschaltbar ist, wobei zu filternde Signale von einem Eingang über einen Addierer einem Ausgang zuführbar sind und die Signale am Ausgang über ein Verzögerungsglied zum Addierer rückführbar sind. Ein derartiger Filter ist aus dem Dokument Electronics and Communications in Japan, Bd. 67, Nr.8, August 1984, New York, US; Seiten 31-40 bekannt.

Die Funktion von Filtern kann durch kurzzeitige Störungen der zu filternden Signale erheblich beeinträchtigt werden. So sind beispielsweise in Rundfunkempfängern Tiefpaßfilter zur Ableitung eines die Empfangsfeldstärke repräsentierenden Signals vorgeschlagen worden, beispielsweise in der deutschen Patentanmeldung P 43 09 518.6 (veröffentlicht am 6.10.94) der Anmelderin. Es sind ferner Rundfunkempfänger bekanntgeworden, bei denen sehr schnell von einer auf eine andere Empfangsfrequenz umgeschaltet wird. Dieses ist insbesondere zur Prüfung der Empfangswürdigkeit von sogenannten alternativen Frequenzen erforderlich. Hierbei ist es wiederum wichtig, möglichst schnell nach dem Umschalten ein die Empfangsfeldstärke repräsentierendes Signal zu erhalten.

Es ist daher Aufgabe der vorliegenden Erfindung, ein digitales Filter anzugeben, das zwischen einer ersten Charakteristik und einer zweiten Charakteristik umschaltbar ist und nach dem Umschalten von der zweiten Charakteristik auf die erste Charakteristik möglichst ohne Einschwingvorgang die Filterung des zugeführten Signals durchführt. Die erste Charakteristik kann beispielsweise einem Tiefpaß entsprechen.

Diese Aufgabe wird erfindungsgemäß durch die Merkmale des Anspruchs 1 gelöst.

Dem Dokument EP-A-0 135 024 ist ein Filter mit umschaltbaren Koeffizienten zu entnehmen.

Das erfindungsgemäße Filter hat den Vorteil, daß das Verzögerungsglied beim Einschalten der ersten Filter-Charakteristik bereits mit dem für die Rückführung zu verwendenden Abtastwert geladen ist. Die zweite Charakteristik kann beispielsweise einem Allpaß entsprechen. Eine gleichbleibende Übertragung der tiefen Frequenzen wird bei dem erfindungsgemäßen digitalen Filter dadurch erzielt, daß im Falle der zweiten Charakteristik der erste Koeffizient gleich dem Quotienten aus dem ersten und der Differenz aus 1 und dem zweiten Koeffizienten im Falle der ersten Charakteristik ist.

Zur Realisierung des erfindungsgemäßen Filters steht eine Vielzahl von digitalen Bauelementen und Baugruppen zur Verfügung. Häufig ist deren Genauigkeit begrenzt, beispielsweise auf 16 Binärstellen an Eingängen von Multiplizierern und bei Speicherbausteinen. Um trotzdem in anderen Schaltungsteilen mit Signalen einer höheren Quantisierungsgenauigkeit arbeiten zu können, ist bei einer Weiterbildung der Erfindung vorgesehen, daß die Ausgangssignale des Addierers in höherwertige und niederwertige Binärstellen aufgespalten werden, daß die höherwertigen und die niederwertigen Binärstellen einerseits und der zweite Koeffizient andererseits je einem zweiten Multiplizierer zugeführt werden, deren Ausgangssignale über einen weiteren Addierer dem Addierer zugeleitet werden. Bei dieser Weiterbildung kann eine Verarbeitung der niederwertigen Binärstellen derart durchgeführt werden, daß die niederwertigen Binärstellen vor der Zuführung zum Verzögerungsglied in Richtung auf höherwertige Binärstellen verschoben werden und daß die Ausgangssignale des für die niederwertigen Binärstellen vorgesehenen zweiten Multiplizierers entsprechend auf niederwertige Binärstellen verschoben werden.

Eine bevorzugte Anwendung des erfindungsgemäßen Filters ist dadurch gekennzeichnet, daß die Eingangssignale amplitudendemodulierte Zwischenfrequenzsignale eines Rundfunkempfängers sind und daß die Koeffizienten auf die zweite Charakteristik umgeschaltet werden, wenn in den Zwischenfrequenzsignalen Störungen zu erwarten sind, welche nicht in ein gefiltertes Ausgangssignal eingehen sollen. Vorzugsweise ist dabei vorgesehen, daß eine Umschaltung der Koeffizienten auf die zweite Charakteristik während des Umschaltens des Rundfunkempfängers von einer Empfangsfrequenz in eine andere und der damit verbundenen Einschwingvorgänge vorgenommen wird.

Ausführungsbeispiele der Erfindung sind in der Zeichnung anhand mehrerer Figuren dargestellt und in der nachfolgenden Beschreibung näher erläutert. Es zeigt:
- Fig. 1: ein Blockschaltbild eines ersten Ausführungsbeispiels,
- Fig. 2: ein Blockschaltbild eines zweiten Ausführungsbeispiels und
- Fig. 3: ein erfindungsgemäßes Filter innerhalb eines Rundfunkempfängers, ebenfalls als Blockschaltbild.

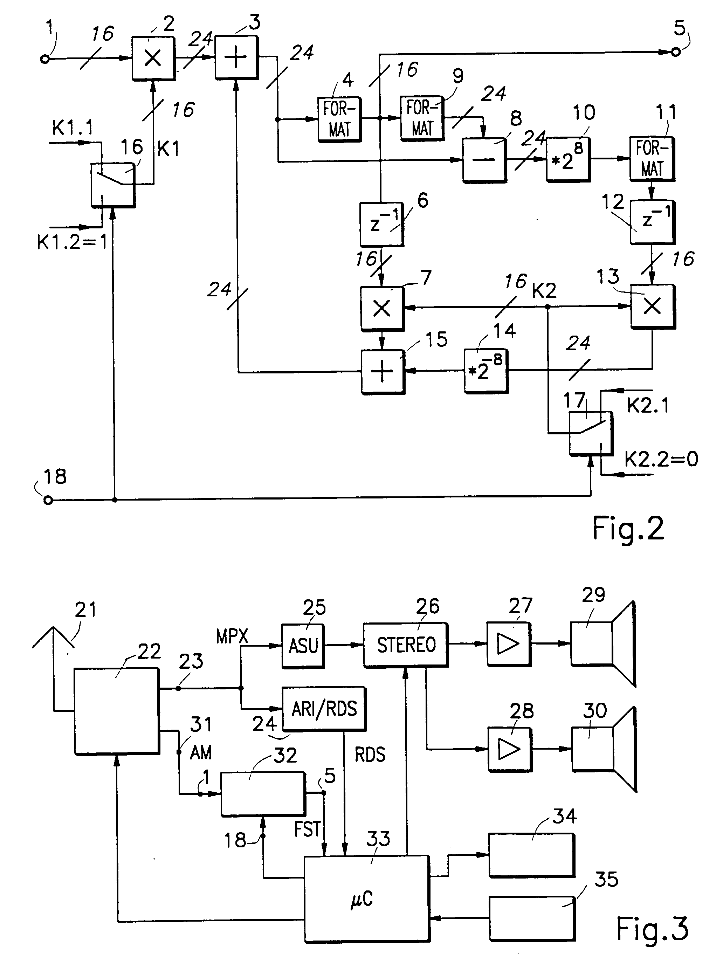

Gleiche Teile sind in den Figuren mit gleichen Bezugszeichen versehen. Zur Vermeidung von Verwechslungen mit den Bezugszeichen sind Bitbreiten in Fig. 2 kursiv dargestellt.

Das erfindungsgemäße Filter kann auf verschiedene Weise verwirklicht werden. So können beispielsweise einzelne oder Gruppen der dargestellten Blöcke durch geeignete Schaltungen, insbesondere integrierte Schaltungen, realisiert werden. Bei sehr hohem Integrationsgrad ist es ferner möglich, die gesamte digitale Signalverarbeitung des Empfängers in einem integrierten Schaltkreis zu realisieren, wobei Signalverarbeitungsschritte, wie beispielsweise Filterungen oder nichtlineare Wichtungen, durch Rechenoperationen durchgeführt werden. Innerhalb eines integrierten Schaltkreises können zur Realisierung eines Empfängers mit der erfindungsgemäßen Schaltungsanordnung auch digitale Signalprozessoren und andere digitale Schaltungen, wie beispielsweise Schieberegister, Flip-Flops usw., gemeinsam angeordnet sein.

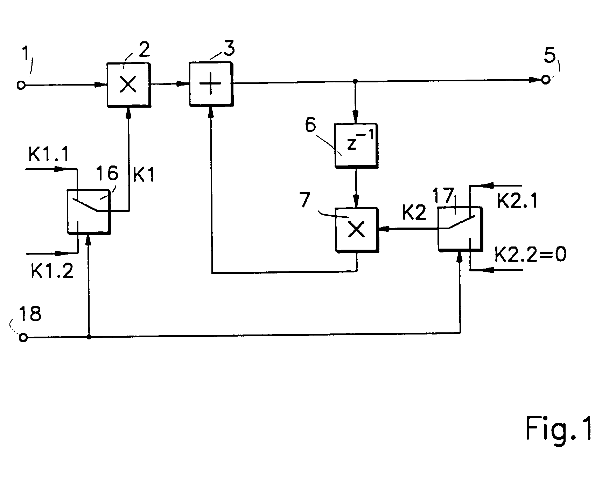

Das in Fig. 1 dargestellte Filter ist ein rekursives Filter erster Ordnung. Die zu filternden Signale werden einem Eingang 1 zugeführt und gelangen über einen ersten Multiplizierer 2 zu einem Addierer 3. Die Ausgangssignale des Addierers 3 werden und einem Ausgang 5 zugeleitet. Das Ausgangssignal wird bei 6 um eine Abtastperiode verzögert und einem Multiplizierer 7 zugeleitet, der Teil einer Signalrückführung zum Addierer 3 ist.

Dem Multiplizierer 2 wird ein Koeffizient K1 zugeführt, der zwischen den Werten K1.1 und K1.2 = K1.1/(1-K2.1) mit Hilfe eines Umschalters 16 umschaltbar ist.

Der Koeffizient K2 für die Multiplizierer 7 und 13 ist mit Hilfe eines Umschalters 17 zwischen den Werten K2.1 und K2.2 = 0 umschaltbar. Beide Umschalter 16, 17 werden von einem bei 18 zugeführten Schaltsignal gesteuert.

Befinden sich die Umschalter 16, 17 in der gezeichneten oberen Stellung, so gelangen die Koeffizienten K1.1 und K2.1 zur Anwendung. Diese weisen beispielsweise die Zahlenwerte K1.1 = 0,125 und K2.1 = 0,875 auf. Das Filter arbeitet dann als rekursives Tiefpaßfilter erster Ordnung. In der unteren Stellung wird in diesem Fall keine Filterung bewirkt. Der Signalpfad zwischen dem Eingang 1 und dem Ausgang 5 stellt einen Allpaß mit dem Übertragungsmaß K1.2 dar. Es wird jedoch das Verzögerungsglied 6 laufend mit den Abtastwerten des bei 1 zugeführten und bei 2 bewerteten Signals geladen. Erfolgt dann wieder eine Umschaltung auf die Tiefpaß-Charakteristik, ist kein erneutes Einschwingen des Filters erforderlich.

Bei dem Ausführungsbeispiel nach Fig. 2 weisen die zugeführten Signale 16 Binärstellen bzw. eine Bitbreite von 16 auf, während die Ausgangssignale des ersten Multiplizierers 2 24 und die Ausgangssignale des Addierers 3 24 Bit breit sind. Nach einer Formatwandlung bei 4 entstehen Signale, welche den 16 höchstwertigen Bits der Ausgangssignale des Addierers 3 entsprechen.

Die nicht im Ausgangssignal vorhandenen acht niederwertigen Binärstellen werden zwar nicht für das Ausgangssignal, jedoch für das zum Addierer 3 zurückgeführte Signal benötigt. Diese Binärstellen werden mit Hilfe eines Subtrahierers 8 und eines Formatwandlers 9 vom Ausgangssignal des Addierers 3 abgetrennt und bei 10 um acht Binärstellen nach links geschoben, so daß sie im mittleren Byte des 24 Bit breiten Signals liegen.

Nach einer weiteren Formatwandlung bei 11 entsteht ein 16 Bit breites Signal, dessen acht niederwertigen Bits die acht niederwertigen Bits des Ausgangssignals des Addierers 3 darstellen. Dieses Signal wird bei 12 um eine Abtastperiode verzögert und bei 13 wie die 16 höherwertigen Binärstellen mit einem Koeffizienten K2 multipliziert. Von dem 24 Bit breiten Ausgangssignal des Multiplizierers 13 werden alle Binärstellen wieder um acht Stellen in Richtung der niederwertigen Binärstellen verschoben (bei 14) und den 24 höherwertigen Binärstellen bei 15 zugeführt. Der Ausgang des Addierers 15 ist dann mit dem Addierer 3 verbunden.

Fig. 3 zeigt wesentliche Teile eines Rundfunkempfängers, insbesondere solche Teile, die zur Erläuterung der Funktion eines erfindungsgemäßen Filters innerhalb des Rundfunkempfängers erforderlich sind. Das über eine Antenne 21 empfangene Signal wird in einem Empfangsteil (Tuner) 22 in an sich bekannter Weise verstärkt, selektiert und demoduliert. Einem Ausgang 23 des Empfangsteils 22 ist ein demoduliertes Multiplexsignal MPX entnehmbar, das in an sich bekannter Weise einem Verkehrsfunk/RDS-Decoder 24 und über eine Schaltung 25 zur Störunterdrückung einem Stereodecoder und Audioprozessor 26 zugeführt wird. Die entstehenden Audiosignale werden in bekannter Weise mit Hilfe zweier Endstufen 27, 28 und zweier Lautsprecher 29, 30 wiedergegeben. Von dem Decoder 24 erzeugte Radio-Daten-Signale RDS werden einem Eingang eines Mikrocomputers 33 zugeleitet.

Das Empfangsteil 22 weist einen weiteren Ausgang 31 auf, an dem ein Signal AM ansteht, das durch Amplitudendemodulation des FM-Zwischenfrequenzsignals entstanden ist. Dieses wird dem Eingang 1 eines erfindungsgemäßen Filters 32 zugeleitet und dient zur Ableitung eines die Empfangsfeldstärke kennzeichnenden Signals FST, das vom Ausgang 5 des Filters 32 einem Eingang des Mikrocomputers 33 zuführbar ist.

Der Mikrocomputer 33 dient bei dem dargestellten Autoradio zur Steuerung verschiedener Vorgänge, insbesondere zur Einstellung der empfangenen Sender über eine im Empfangsteil 22 vorhandene, jedoch nicht dargestellte PLL-Schaltung und zur Steuerung des Filters 32 über dessen Steuereingang 18. Auch eine Steuerung des Stereodecoders und Audioprozessors 26 mit Hilfe des Mikrocomputers 33 ist vorgesehen. Dabei wird in Abhängigkeit vom Feldstärkesignal FST eine Absenkung der Lautstärke und eine Stereo/Mono-Umschaltung vorgenommen. Der Mikrocomputer 33 ist ferner mit einer Anzeigevorrichtung 34 und einem Bedienteil 35 verbunden.

Wird dem Mikrocomputer 33 durch ein kleines Feldstärkesignal FST angezeigt, daß der zur Zeit empfangene Sender schwächer einfällt, wird vom Mikrocomputer 33 versuchsweise ein anderer Sender (alternativer Sender) eingestellt, der das gleiche Programm sendet, was der Mikrocomputer durch das Radio-Daten-Signal RDS erkennt. Dieses Verfahren ist an sich bekannt und braucht zur Erläuterung des erfindungsgemäßen Filters nicht näher erläutert zu werden.

Beim Übergang vom Empfang eines Senders zum Empfang eines anderen Senders entstehen jedoch Einschwingvorgänge, die sich in Spitzen des Signals AM bemerkbar machen, die nicht auf eine besonders hohe Empfangsfeldstärke schließen lassen. Damit bei der Tiefpaßfilterung des nach den Einschwingvorgängen vorhandenen Signals diese Spitzen nicht stören, wird das Filter 32, wie im Zusammenhang mit Fig. 1 beschrieben wurde, umgeschaltet. Außerdem ist während der Zeit des Übergangs vom Verlassen eines Senders bis zum hingeschwungenen Empfang des anderen Senders eine Auswertung des Signals FST im Mikrocomputer 33 unterbrochen. Sobald jedoch das Empfangsteil 22 auf den neu eingestellten Sender eingeschwungen ist, wird vom Mikrocomputer über den Steuereingang 18 das Filter 32 wieder eingeschaltet und das Signal FST ausgewertet.

## Patentansprüche

1. Digitales Filter, das zwischen einer ersten Charakteristik und einer zweiten Charakteristik umschaltbar ist, wobei zu filternde Signale von einem Eingang (1) über einen Addierer (3) einem Ausgang (5) zuführbar sind und die Signale am Ausgang (5) über ein Verzögerungsglied (6,12) zum Addierer (3) rückführbar sind, dadurch gekennzeichnet, daß zwischen dem Eingang (1) und einem ersten Eingang des Addierers (3) ein erster Multiplizierer (2) und zwischen dem Verzögerungsglied (6, 12) und einem zweiten Eingang des Addierers (3) ein zweiter Multiplizierer (7, 13) angeordnet ist, daß dem ersten Multiplizierer (2) ein erster und dem zweiten Multiplizierer (7, 13) ein zweiter Koeffizient zuführbar ist, wobei die Koeffizienten für die beiden Charakteristiken umschaltbar sind, wobei im Falle der ersten Charakteristik der erste Koeffizient (K1.1) und der zweite Koeffizient (K2.1) jeweils einen vorgebbaren, bestimmten Wert aufweist und im Falle der zweiten Charakteristik der zweite Koeffizient (K2.2) Null und der erste Koeffizient (K1.2) gleich dem Quotienten aus dem ersten (K1.1) und der Differenz aus 1 und dem zweiten Koeffizienten (K2.1) im Falle der ersten Charakteristik ist.

2. Digitales Filter nach Anspruch 1, dadurch gekennzeichnet, daß die Ausgangssignale des Addierers (3) in höherwertige und niederwertige Binärstellen aufgespalten werden, daß die höherwertigen und die niederwertigen Binärstellen einerseits und der zweite Koeffizient andererseits je einem zweiten Multiplizierer (7, 13) zugeführt werden, deren Ausgangssignale über einen weiteren Addierer (15) dem Addierer (3) zugeleitet werden.

3. Digitales Filter nach Anspruch 2, dadurch gekennzeichnet, daß die niederwertigen Binärstellen vor der Zuführung zum Verzögerungsglied in Richtung auf höherwertige Binärstellen verschoben werden und daß die Ausgangssignale des für die niederwertigen Binärstellen vorgesehenen zweiten Multiplizierers (13) entsprechend auf niederwertige Binärstellen verschoben werden.

4. Digitales Filter nach einem der vorhergehenden Ansprüche, dadurch gekennzeichnet, daß die Eingangssignale amplitudendemodulierte Zwischenfrequenzsignale eines Rundfunkempfängers sind und daß die Koeffizienten auf die zweite Charakteristik umgeschaltet werden, wenn in den Zwischenfrequenzsignalen Störungen zu erwarten sind, welche nicht in ein gefiltertes Ausgangssignal eingehen sollen.

5. Digitales Filter nach Anspruch 1, dadurch gekennzeichnet, daß eine Umschaltung der Koeffizienten auf die zweite Charakteristik während des Umschaltens des Rundfunkempfängers von einer Empfangsfrequenz in eine andere und der damit verbundenen Einschwingvorgänge vorgenommen wird.

## Claims

1. Digital filter which can be switched over between a first characteristic and a second characteristic, it being possible to supply signals which are to be filtered from an input (1) via an adder (3) to an output (5), and it being possible for the signals at the output (5) to be fed back via a delay element (6, 12) to the adder (3), characterized in that a first multiplier (2) is arranged between the input (1) and a first input of the adder (3), and a second multiplier (7, 13) is arranged between the delay element (6, 12) and a second input of the adder (3), in that a first coefficient can be supplied to the first multiplier (2) and a second coefficient can be supplied to the second multiplier (7, 13), it being possible to switch over the coefficients for the two characteristics, in the case of the first characteristic, the first coefficient (K1.1) and the second coefficient (K2.1) in each case having a specific value which can be predetermined, and in the case of the second characteristic, the second coefficient (K2.2) being zero and the first coefficient (K1.2) being equal to the quotient of the first coefficient (K1.1) in the case of the first characteristic and the difference between 1 and the second coefficient (K2.1) in the case of the first characteristic.

2. Digital filter accurding to Claim 1, characterized in that the output signals of the adder (3) are split into more highly significant and less significant binary digits, in that the more highly significant and the less significant binary digits on the one hand and the second coefficient on the other hand are supplied to in each case one second multiplier (7, 13), whose output signals are passed via a further adder (15) to the adder (3).

3. Digital filter according to Claim 2, characterized in that the less significant binary digits are shifted in the direction of the more highly significant binary digits before being supplied to the delay element, and in that the output signals of the second multiplier (13), which is provided for the less significant binary digits, are correspondingly shifted toward less significant binary digits.

4. Digital filter according to one of the preceding claims, characterized in that the input signals are amplitude-demodulated intermediate-frequency signals of a broadcast radio receiver, and in that the coefficients are switched over to the second characteristic when interference can be expected in the intermediate-frequency signals, which interference is not intended to be included in a filtered output signal.

5. Digital filter according to Claim 1, characterized in that the coefficients are switched over to the second characteristic while the broadcast radio receiver is being switched over from one received frequency to another and the transient processes associated with this operation are taking place.

## Revendications

1. Filtre numérique que l'on peut commuter entre une première caractéristique et une seconde caractéristique, des signaux à filtrer pouvant être amenés à partir d'une entrée (1), par l'intermédiaire d'un additionneur (3), à une sortie (5), et les signaux à la sortie (5) pouvant être amenés, par l'intermédiaire d'un organe de temporisation (6, 12), à un additionneur (3),
caractérisé en ce que
entre l'entrée (1) et une première entrée de l'additionneur (3), on dispose un premier multiplicateur (2) et, entre l'organe de temporisation (6, 12) et une seconde entrée de l'additionneur (3), on dispose un second multiplicateur (7, 13) et en ce qu'on peut amener au premier multiplicateur (2) un premier coefficient et au second multiplicateur (7, 13) un second coefficient, les coefficients pour les deux caractéristiques étant commutables, alors que dans le cas de la première caractéristique, le premier coefficient (K1.1) et le second coefficient (K2.1) présentent respectivement une valeur déterminée, prédéfinissable et, dans le cas de la seconde caractéristique, le deuxième coefficient (K2.2) est nul et le premier coefficient (K1.2) est égal au quotient du premier coefficient (K1.1) et de la différence par rapport à 1 du deuxième coefficient (K2.1) dans le cas de la première caractéristique.

2. Filtre numérique selon la revendication 1,
caractérisé en ce que
les signaux de sortie de l'additionneur (3) sont répartis en bits de haute valeur et de basse valeur, et en ce que les bits de haute valeur et les bits de basse valeur, d'une part, et le second coefficient d'autre part, sont amenés chacun à un multiplicateur (7, 13) dont les signaux de sortie sont amenés, par l'intermédiaire d'un autre additionneur (15), à l'additionneur (3).

3. Filtre numérique selon la revendication 2,
caractérisé en ce que
les bits de basse valeur sont, avant leur amenée à l'organe de temporisation, poussés en direction des bits de haute valeur, et en ce que les signaux de sortie du second multiplicateur (13), prévu pour les bits de basse valeur, sont poussés en conséquence sur les bits de basse valeur.

4. Filtre numérique selon l'une des revendications précédentes,
caractérisé en ce que
les signaux d'entrée sont des signaux de fréquence intermédiaire, démodulés en amplitude, d'un récepteur radio, et en ce que les coefficients sont commutés sur la deuxième caractéristique quand on doit s'attendre à des parasites dans les signaux de fréquence intermédiaire, parasites qui ne doivent pas entrer dans un signal de sortie filtré.

5. Filtre numérique selon la revendication 1,
caractérisé en ce qu'
on effectue une commutation des coefficients sur la seconde caractéristique pendant la commutation du récepteur radio d'une fréquence de réception sur une autre, avec les processus de calage que cela entraîne.
